# EUROPÄISCHE PATENTSCHRIFT

(11) **EP 3 649 511 B1**
(45) Veröffentlichungstag und Bekanntmachung des Hinweises auf die Patenterteilung: **27.12.2023**
(21) Anmeldenummer: 18745502.7
(22) Anmeldetag: 04.07.2018
(51) Int. Cl.: G03F 7/20

(54) **ERZEUGUNG VON BELICHTETEN STRUKTUREN AUF EINEM WERKSTÜCK**
PRODUCING LIGHT-EXPOSED STRUCTURES ON A WORKPIECE
PRODUCTION DE STRUCTURES ILLUMINÉES SUR UNE PIÈCE

(30) Priorität: 06.07.2017 DE 102017115169
(43) Veröffentlichungstag der Anmeldung: 13.05.2020
(73) Patentinhaber: temicon GmbH, 44263 Dortmund (DE)
(72) Erfinder: HUMBACH, Oliver, 44388 Dortmund (DE); RUHL, Thomas, 44269 Dortmund (DE)
(74) Vertreter: Kalkoff & Partner Patentanwälte mbB
(86) Internationale Anmeldenummer: PCT/EP2018/068146
(87) Internationale Veröffentlichungsnummer: WO 2019/008067

(56) Entgegenhaltungen:
- WO-A1-2010/080378
- US-A1- 2013 323 651
- US-B1- 6 882 477

## Beschreibung

Die Erfindung betrifft eine Vorrichtung und ein Verfahren zur Erzeugung von belichteten Strukturen auf einem Werkstück mit lichtempfindlicher Oberfläche.

Die Erzeugung von belichteten Strukturen kann insbesondere verwendet werden zur Herstellung von Oberflächenprofilen.

Beispielsweise zeigt die DE 43 33 620 A1 eine Anordnung und ein Verfahren zur Erzeugung von Dosisprofilen für die Herstellung von Oberflächenprofilen, insbesondere für Mikrolinsen. Ein geformter Strahlungsfleck erzeugt bei konstanter, geradliniger Bewegung nach Entwicklung eines auf der Oberfläche aufgebrachten Resists eine Profilform. Der geformte Strahl wird in mindestens einer Koordinate so relativ zum Objekt bewegt, dass er die Oberfläche des Objekts in einer zeitlich definierten Weise überstreicht und diese dabei eine örtlich unterschiedliche Strahlendosis erhält. Zur Strahlformung einer Strahlenquelle, beispielsweise Lichtquelle, Röntgenstrahlquelle, Elektronenquelle oder Ionenquelle, kann eine Blende verwendet werden. Für die Herstellung von Mikrolinsen werden bevorzugt parabelförmige Strahlformen und Strahlformen mit fresnelscher Struktur verwendet.

In der US 6 882 477 B1 wird SBIL (Scanning Beam Interference Lithography) beschrieben, wobei ein Substrat auf einem Objekttisch unter überlappenden und interferierenden Paaren kohärenter Strahlen bewegt wird. Das gebildete Interferenzmuster bildet einen "Pinsel" mit dem periodische und quasi-periodische Muster auf das Substrat geschrieben werden. Die Phase des Interferenzmusters ist phasenstarr mit der Bewegung des Objekttisches.

In "Fast dynamic interferometrie lithography for lage submicrometric period diffraction gratings production" von Gâté et al, Optical Engineering 52 (9), 091712 (September 2013) werden große periodische Gitter mittels Laser geschrieben. Der Schreibkopf besteht aus einer Phasenmaske, mit der ein Beugungsmuster auf ein mit Photoresist beschichtetes Substrat projiziert wird. Durch kontinuierliche Bewegung des Substrats können ein- oder zweidimensionale Gitter auf großen Flächen erzeugt werden.

US 2013/323651 A1 offenbart ein Verfahren und eine Vorrichtung zur Erzeugung eines Musters mit periodischen Merkmalen auf einer photosensitiven Schicht. Das Verfahren umfasst Schritte der Bereitstellung eines Substrats mit der Schicht, Bereitstellung einer Maske, Anordnen des Substrats so, dass die Maske einen Anstellwinkel relativ zum Substrat in einer ersten dazu orthogonalen Ebene aufweist und Bereitstellung von kollimiertem Licht zur Beleuchtung des Maskenmusters. So wird ein transmittiertes Lichtfeld mit transversalen Intensitätsverteilungen zwischen Talbot-Ebenen erzeugt, die in einer Talbot-Distanz voneinander entfernt sind, so dass das transmittierte Lichtfeld in der ersten Ebene eine Intensitäts-Einhüllende aufweist. Die Maske wird beleuchtet, während das Substrat relativ zur Maske in einer Richtung parallel zur ersten Ebene bewegt wird. Der Anstellwinkel und die Intensitäts-Einhüllende sind so arrangiert, dass die Schicht dem Mittelwert der transversalen Intensitätsverteilungen ausgesetzt ist.

Es kann als eine Aufgabe der Erfindung angesehen werden, eine Vorrichtung und ein Verfahren vorzuschlagen, mit denen auch relativ feine Strukturen auf größeren Flächen mit hoher Qualität erzeugt werden können.

Erfindungsgemäß wird die Aufgabe gelöst durch eine Vorrichtung nach Anspruch 1 und ein Verfahren nach Anspruch 13. Abhängige Ansprüche beziehen sich auf vorteilhafte Ausführungsformen der Erfindung.

Bei dem erfindungsgemäßen Verfahren und der erfindungsgemäßen Vorrichtung werden jeweils belichtete Strukturen auf der Oberfläche eines Werkstücks erzeugt. Die Oberfläche des Werkstücks ist lichtempfindlich, beispielsweise durch eine lichtempfindliche Schicht wie ein Fotolack (Resist). Dabei können verschiedene Formen von Werkstücken und zugehörigen Oberflächen belichtet werden, beispielsweise ebene Oberflächen oder gekrümmte Oberflächen. Insbesondere kann die Oberfläche eine Zylinderoberfläche sein.

Erfindungsgemäß wird ein streifenförmiges Beleuchtungsmuster erzeugt durch Beleuchtung eines ebenen Beugungsgitters, bevorzugt eines Amplitudengitters, mit einer Lichtquelle. Als Lichtquelle ist erfindungsgemäß eine kohärente Lichtquelle vorgesehen, insbesondere eine Laser-Lichtquelle. Das hiervon beleuchtete Beugungsgitter kann bspw. ein Liniengitter sein, das in einer Längsrichtung verlaufende linienförmige lichtdurchlässige Bereiche aufweist. Bevorzugt ist eine Liniengitter-Maske mit einer hohen Anzahl Linien mit regelmäßiger Struktur, das heißt jeweils gleicher Linienbreite und gleichen Abständen. Die Strukturperiode von bevorzugten Liniengitter-Masken kann beispielsweise in einem Bereich von 100 nm bis zu mehreren Mikrometern liegen, bevorzugt in einem Bereich von 200 nm bis 1 µm. Die Maske kann beispielsweise rechteckig oder quadratisch sein mit typischen Kantenlängen im Bereich von beispielsweise 10 bis 400 mm.

Das Licht der Lichtquelle wird bevorzugt mit einer definierten Intensitätsverteilung auf das Beugungsgitter gelenkt, beispielsweise durch eine Optik mit einer oder mehreren Linsen und/oder Prismen. Die Anordnung kann so gewählt sein, dass sich eine beispielsweise gauß- oder trapezförmige Intensitätsverteilung auf der Oberfläche des Beugungsgitters ergibt. Der Beleuchtungsfleck kann dabei beispielsweise rund sein, das heißt mindestens im Wesentlichen gleiche Abmessungen in der zu den Linien des Beleuchtungsmusters parallelen Längsrichtung (nachfolgend auch bezeichnet als X-Richtung) sowie in quer hierzu verlaufender Querrichtung (nachfolgend: Y-Richtung) aufweisen. In der Praxis wird der Beleuchtungsfleck nicht scharf berandet sein, sondern einem i.d.R. stetigen Intensitätsverlauf entsprechen (bspw. Gaußkurve), so dass man als Ausdehnung des Beleuchtungsflecks bspw. eine Linie betrachten kann, bei der die Intensität gegenüber dem Maximum um ein festes Verhältnis verringert ist. Als festes Verhältnis wird bevorzugt ein Wert von 0,00034% betrachtet (was bei einer Gauß-Verteilung einem Wert von 6σ entsprechend würde). Dabei sind abweichende Ausdehnungen des Beleuchtungsflecks in den beiden Raumrichtungen bevorzugt, beispielsweise eine elliptische oder streifenförmige Intensitätsverteilun1g. Bevorzugt weist der Beleuchtungsfleck eine geringere Ausdehnung in der Längsrichtung (X-Richtung) auf als in Querrichtung (Y-Richtung) auf, bevorzugt entspricht die Ausdehnung in Y-Richtung mindestens dem 3-fachen, besonders bevorzugt sogar mindestens dem 10-fachen der Ausdehnung in X-Richtung. Durch eine möglichst große Ausdehnung in Y-Richtung ergibt sich eine große Musterbreite, so dass bei einem Verfahren in X-Richtung eine große Fläche überstrichen wird. Durch eine möglichst kleine Ausdehnung in X-Richtung ergibt sich im Fall einer nicht vollständig parallelen Anordnung des Streifenmusters zum Verfahrweg in X-Richtung eine nur geringe Beeinflussung der belichteten Struktur, während bei größerer X-Ausdehnung eine Abweichung von der parallelen Anordnung größere Auswirkungen hat.

In einer weiter bevorzugten Anordnung reicht die Ausdehnung des Beleuchtungsflecks nicht bis zum Rand des Beugungsgitters, um optische Randeffekte möglichst zu vermeiden. Der Beleuchtungsfleck - wiederum gemessen nach dem o.g. 6σ-Kriterium - hat zumindest in Querrichtung Y (und bevorzugt auch in Längsrichtung X) eine geringere Breite als das Beugungsgitter, besonders bevorzugt ist das Beugungsgitter mindestens 30% größer oder sogar mindestens doppelt so groß.

Durch die Verwendung des Beugungsgitters wird ein streifenförmiges Beleuchtungsmuster erzeugt, bevorzugt als Beugungs- bzw. Interferenzmuster. Dieses entsteht, wenn die Wellenlänge des Lichts in der Größenordnung der Gitterperiode der Maske liegt oder kleiner ist. Bspw. kann das Verhältnis der Wellenlänge λ des Lichts zu der Gitterperiode 0,1 bis 1 betragen, bevorzugt 0,8 bis 1. Hinter dem Beugungsgitter bildet sich dann ein Interferenzmuster aus, das die doppelte Periode bspw. einer Gitterstruktur eines Liniengitters hat. Das Interferenzfeld ist mehrere Mikrometer tief und besteht aus einer Abfolge von äquidistanten Intensitätsmaxima und dazwischen angeordneten Intensitätsminima.

Mit dem so erzeugten streifenförmigen Beleuchtungsmuster wird die Oberfläche des Werkstücks beleuchtet. Diese ist bevorzugt in einem geringen Abstand von ca. 1 µm bis 150 µm hinter dem Beugungsgitter angeordnet. Bevorzugt wird der Abstand zwischen dem Beugungsgitter und der Werkstückoberfläche in Abhängigkeit von der Belichtungswellenlänge gewählt, bspw. im Bereich des 20 bis 300-fachen der Wellenlänge.

Das streifenförmige Beleuchtungsmuster weist eine Musterbreite in Querrichtung (Y-Richtung) auf. Es weist dabei eine Intensitätsverteilung auf, bei der die Maxima (Streifen) in Querrichtung von der Mitte her zu den Rändern abnehmen. Während sich Anteile des Beleuchtungsmusters mit geringer Intensität in Querrichtung weiter erstrecken können, wird als Musterbreite bevorzugt diejenige Breite betrachtet, bei der an den Rändern die Intensität der Maxima auf 0,00034% (6σ) des zentralen Hauptmaximums abgefallen ist.

Erfindungsgemäß wird die optische Einheit, die das streifenförmige Beleuchtungsmuster erzeugt, relativ zur Oberfläche des Werkstücks entlang einer Wegfolge verfahren. Dies kann bei feststehendem Werkstück durch ein Verfahren der optischen Einheit erreicht werden, oder bei feststehender optischer Einheit durch eine Bewegung des Werkstücks, beispielsweise ein Verfahren oder Drehen. Es können auch sowohl Werkstück als auch optische Einheit so bewegt werden, dass sich eine Relativbewegung zwischen den beiden so ergibt, dass sich die angegebene Wegfolge des Beleuchtungsmusters auf der Werkstückoberfläche ergibt.

Erfindungsgemäß umfasst die Wegfolge mindestens einen ersten und zweiten Verfahrweg in der Längsrichtung (X-Richtung), um auf der Oberfläche des Werkstücks eine erste und parallel dazu eine zweite belichtete streifenförmige Struktur zu erzeugen. Dabei sind der erste und der zweite Verfahrweg in Querrichtung voneinander beabstandet. Der Abstand zwischen dem ersten und zweiten Verfahrweg beträgt weniger als die Musterbreite, so dass sich auf der Oberfläche des Werkstücks ein Überlappungsbereich ergibt, das heißt ein Bereich, in dem sowohl auf dem ersten als auch auf dem zweiten Verfahrweg belichtet wird.

Erfindungsgemäß überlappen sich die auf dem ersten und zweiten Verfahrweg erzeugten ersten und zweiten belichteten Strukturen teilweise so, dass Streifen der beiden Strukturen aufeinander liegend angeordnet sind, also gleichphasig. Im bevorzugten Fall von periodischen Strukturen sind die erste und zweite Struktur bevorzugt um ein ganzzahliges Vielfaches der Musterperiode gegeneinander versetzt, so dass die jeweiligen Streifen beziehungsweise Maxima des Beleuchtungsmusters sich auf der Werkstückoberfläche räumlich überlagern.

Die phasengleiche Positionierung erfolgt bevorzugt mit einer hohen Genauigkeit, so dass Abweichungen möglichst unter 20% der Musterperiode liegen.

Das hinter dem Beugungsgitter gebildete Beleuchtungsmuster weist nicht nur in Querrichtung zur optischen Achse, sondern auch in der Z-Richtung, also entlang der optischen Achse, Maxima und Minima auf (Talbot-Effekt). Es hat also eine begrenzte Tiefenschärfe. Um trotzdem auf der Oberfläche belichtete Strukturen mit einem scharfen Streifenmuster zu erzeugen ist erfindungsgemäß vorgesehen, das Beugungsgitter gegenüber zumindest einem Teil der belichteten Oberfläche schräg angestellt anzuordnen. Betrachtet werden kann hier bspw. der Teil der Oberfläche, der durch den Beleuchtungsfleck (dessen Grenzen ggfs. durch das 6σ Kriterium ermittelt werden) gleichzeitig beleuchtet wird.

Durch eine solche schräge Anordnung ergibt sich bei der Relativbewegung von Beleuchtungsmuster und Oberfläche in der Längsrichtung (X-Richtung) ein Ausgleich der unterschiedlichen Lagen der Maxima in Z-Richtung.

Die Schrägstellung kann einerseits erreicht werden durch Anordnung des Beugungsgitters schräg zur optischen Achse der Lichtquelle. Das Beugungsgitter und die Lichtquelle (sowie ggf. eine dazwischen angeordnete Optik) können dann so angeordnet sein, dass das Licht der Lichtquelle unter einem Winkel α zu einer zur Oberfläche der Maske senkrechten Normalrichtung N auf die Maske fällt.

Die Lichtquelle und das Beugungsgitter können aber auch gerade zueinander ausgerichtet sein, wenn die Oberfläche des Werkstücks oder zumindest ein Teil hiervon schräg zur gemeinsamen optischen Achse von Lichtquelle und Beugungsgitter ausgerichtet ist. Wenn zumindest in einem Teil der von dem Beleuchtungsmuster belichteten Oberfläche des Werkstücks eine Schrägstellung vorliegt, d.h. eine Flächennormale F der Oberfläche unter einem Winkel β zu einer zur Oberfläche der Maske senkrechten Normalrichtung N angeordnet ist, ergibt sich bei anschließender Relativbewegung in Längsrichtung (X-Richtung) ein scharfes Streifenmuster.

Dabei kann bspw. eine ebene Oberfläche des Werkstücks schräg angeordnet sein zum ebenen Beugungsgitter, so dass sich an jedem beleuchteten Punkt der Oberfläche ein Winkel β zwischen der Flächennormalen F und der Normalrichtung N des Beugungsgitters ergibt.

Der Effekt, dass die unterschiedlichen Lagen der Maxima in Z-Richtung durch die Relativbewegung in Längsrichtung ausgeglichen werden, ergibt sich auch dann, wenn das Beugungsgitter nur zu einem Teil der gleichzeitig belichteten Oberfläche schräg angeordnet ist, also bspw. wenn die Oberfläche gekrümmt ist. Dann sind die Flächennormalen F der Oberfläche an verschiedenen Orten des beleuchteten Teils der Oberfläche in voneinander leicht abweichende Richtungen ausgerichtet, so dass sich bei Beleuchtung mit dem vom ebenen Beugungsgitter gebildeten Beleuchtungsmuster Schrägstellungen ergeben.

Beispielsweise kann die Oberfläche eine Zylinderoberfläche sein und das Werkstück zur Erzielung der Relativbewegung gedreht werden, so dass sich der gewünschte Effekt einstellt.

Der Anstellwinkel β zwischen dem Beugungsgitter und der Oberfläche des Werkstücks und/oder der Anstellwinkel α des Beugungsgitters gegenüber der Lichtquelle kann beispielsweise zwischen 0,02 Grad und 2 Grad betragen. Bevorzugt kann der Winkel in Abhängigkeit von der Wellenlänge λ des verwendeten Lichts und dem Abstand a zwischen dem Beugungsgitter und der Werkstückoberfläche gewählt werden, bspw. so, dass ein Sinuswert des Winkels im Bereich des 5-fachen Verhältnisses der Wellenlänge zum Abstand (5 * λ/a) bis zum 50-fachen dieses Verhältnisses (50 * λ /a) liegt.

Mit der erfindungsgemäßen Vorrichtung und dem erfindungsgemäßen Verfahren kann somit sehr exakt ein Belichtungsmuster auf der Werkstückoberfläche erzeugt werden.

Mittels der optischen Einheit ist die Erzeugung sehr feiner Muster möglich, insbesondere wenn bei Interferenzmustern ein Beleuchtungsmuster mit doppelter Periode der Maskengitterstruktur erzielt wird. Gleichzeitig kann durch die Überlagerung von mehreren Verfahrwegen in X-Richtung und durch Überlagerung der hierdurch erzeugten belichteten Strukturen eine relativ große Fläche mit dem gewünschten Muster belichtet werden. Dabei ist die Anwendung natürlich nicht auf die Überlagerung der Belichtung von zwei Verfahrwegen beschränkt, sondern auf der Oberfläche des Werkstücks bevorzugt kann durch eine Vielzahl von in Y-Richtung versetzten Verfahrwegen eine große Fläche von bspw. mindestens 100 cm², weiter bevorzugt mindestens 1000 cm², bis hin zu 1 m² oder mehr belichtet werden.

Gemäß einer Weiterbildung der Erfindung kann eine Ansteuervorrichtung zur automatischen Ansteuerung der Verfahrvorrichtung gemäß der Wegfolge vorgesehen sein. Die Wegfolge kann einerseits Verfahrwege in X-Richtung zur Erzeugung der Belichtung und andererseits Versatzwege zur Positionierung für nachfolgende Verfahrwege umfassen, die mindestens zum Teil in Querrichtung verlaufen. Die Verfahrwege in Längsrichtung können dabei stets gleichsinnig oder alternativ auch gegensinnig durchfahren werden. Die Versatzwege können direkt in Querrichtung oder alternativ auch schräg verlaufen. Während der Versatzwege ist bevorzugt die optische Einheit deaktiviert, so dass keine störende Belichtung während des Verfahrens in Querrichtung erzeugt wird. Die Verfahrvorrichtung kann beispielsweise einen verfahrbaren Schlitten für die optische Einheit aufweisen, der in X-Richtung und/oder in Y-Richtung durch geeignete Aktoren positionierbar ist. Für die Belichtung von Zylinderoberflächen kann die Verfahrvorrichtung eine Drehvorrichtung für ein zylindrisches Werkstück in Verbindung mit einem in Längsrichtung des Zylinders verfahrbaren Schlitten für die optische Einheit umfassen.

Eine möglichst genaue phasengleiche Überlagerung der ersten und zweiten belichteten Struktur stellt einen wichtigen Aspekt der Erfindung dar. Um dies zu erreichen, kann bei bekannter Struktur des Musters, beispielsweise der Musterperiode, eine hochgenaue Ansteuerung der Verfahrvorrichtung vorgegeben werden. Dies kann durch eine Positioniervorrichtung erfolgen, die bspw. gemäß einer externen Referenz-Struktur oder mittels Interferometer-Messung gesteuert wird, die bspw. durch Interferenz erzeugt sein kann.

Gemäß einer Weiterbildung der Erfindung ist die Wegfolge so gewählt, dass eine belichtete Struktur auf der Oberfläche des Werkstücks mindestens im Überlappungsbereich zweier Verfahrwege eine zumindest im Wesentlichen konstante Belichtung aufweist. Unter einer mindestens im Wesentlichen konstanten Belichtung wird verstanden, dass die Belichtungsdosis der einzelnen Streifen beziehungsweise Maxima mit einer Abweichung von nicht mehr als 30 %, bevorzugt nicht mehr als 20 %, bevorzugt nicht mehr als 10 % von einem Mittelwert abweicht, so dass sich also eine regelmäßige Struktur mit im Wesentlichen gleich hohen Maxima ergibt. Um dies zu erreichen, wird der Versatz zwischen dem ersten und zweiten Verfahrweg abhängig von dem Beleuchtungsmuster bevorzugt so gewählt, dass die sich überlagernden Maxima eines Interferenzmusters in Summe gleich hoch sind. So kann eine vollständig regelmäßige Struktur erzielt werden.

Im Fall eines regelmäßigen Beleuchtungsmusters, insbesondere des bevorzugten Interferenzmusters, entspricht eine Musterperiode dem Abstand der Maxima der Intensitätsverteilung des Beleuchtungsmusters auf der Oberfläche des Werkstücks. Eine Versatzstrecke innerhalb der Wegfolge zwischen dem ersten und zweiten Verfahrweg wird so gewählt, dass der Versatz in Querrichtung mit der gewünschten Genauigkeit einem ganzzahligen Vielfachen der Musterperiode entspricht, so dass die gewünschte genaue Überlagerung der Maxima erreicht werden kann. Die Versatzstrecke kann bspw. in Abhängigkeit von der Intensitätsverteilung des Beleuchtungsmusters mit dem Ziel gewählt werden, möglichst eine Angleichung der Belichtungsdosis der einzelnen Streifen zu erreichen. Als günstig haben sich bspw. Versatzstrecken im Bereich von mindestens 10%, bevorzugt mindestens 25% der Musterbreite erwiesen. Um noch eine ausreichende Überlappung zu erzielen, sollte die Versatzstrecke bevorzugt weniger als 90% der Musterbreite, bevorzugt weniger als 60% der Musterbreite betragen.

Insgesamt ist bevorzugt, dass die Wegfolge eine Mehrzahl von parallelen Verfahrwegen in Längsrichtung umfasst, um durch parallele überlappend belichtete Strukturen auf der Oberfläche des Werkstücks eine belichtete Gesamtstruktur mit parallelen Streifen zu erzeugen.

Dabei können auch Strukturen mit überkreuzenden Streifen erzeugt werden, bspw. indem durch Überlagerung von mehreren in Längsrichtung verlaufenden streifenförmigen Belichtungen eine erste belichtete Gesamtstruktur erzeugt und diese erste belichtete Gesamtstruktur mit einer zweiten belichteten Gesamtstruktur überlagert wird, die sich in einer zweiten Längsrichtung erstreckt, die einen Winkel zur ersten Längsrichtung bildet, der größer als 0° ist.

Nachfolgend werden Ausführungsformen der Erfindung anhand von Zeichnungen näher erläutert. Dabei zeigen:
- Fig. 1: in schematischer Seitenansicht eine Vorrichtung zur Belichtung der Oberfläche eines flachen Werkstücks;
- Fig. 2: in schematischer perspektivischer Darstellung die Anordnung einer optischen Einheit vor einem Werkstück;
- Fig. 3: einen Teil einer Liniengittermaske der optischen Einheit aus Fig. 2;
- Fig. 4: eine schematische Darstellung von Intensitäten des auf eine Maske einfallenden Lichts sowie eines resultierenden Interferenzmusters;
- Fig. 4a: eine schematische Darstellung des Interferenzmusters aus Fig. 4 in Seitenansicht;
- Fig. 4b: eine schematische Darstellung eines Interferenzmusters bei schräg angestellter Maske;
- Fig. 4c: eine schematische Darstellung eines Interferenzmusters bei gekrümmter Werkstückoberfläche;
- Fig. 5: in schematischer Darstellung die Bewegung einer optischen Einheit gegenüber dem Werkstück;
- Fig. 6: die Überlagerung verschiedener belichteter Strukturen zu einer belichteten Gesamtstruktur;
- Fig. 7: verschiedene Wegfolgen einer optischen Einheit auf der Oberfläche eines Werkstücks;
- Fig. 8: in schematischer Seitenansicht eine erste Ausführungsform einer optischen Einheit mit gegenüber der Lichtquelle angestellter Maske;
- Fig. 9: in schematischer Seitenansicht eine zweite Ausführungsform einer optischen Einheit mit gegenüber der Oberfläche des Werkstücks angestellter Maske;
- Fig. 10: in schematischer Seitenansicht eine dritte Ausführungsform einer optischen Einheit zur Erzeugung eines Beleuchtungsmusters auf einer gekrümmten Oberfläche,
- Fig. 11a - 11f: die Erzeugung verschiedener Belichtungsmuster auf Werkstück-Oberflächen durch geeignete Wegfolgen.

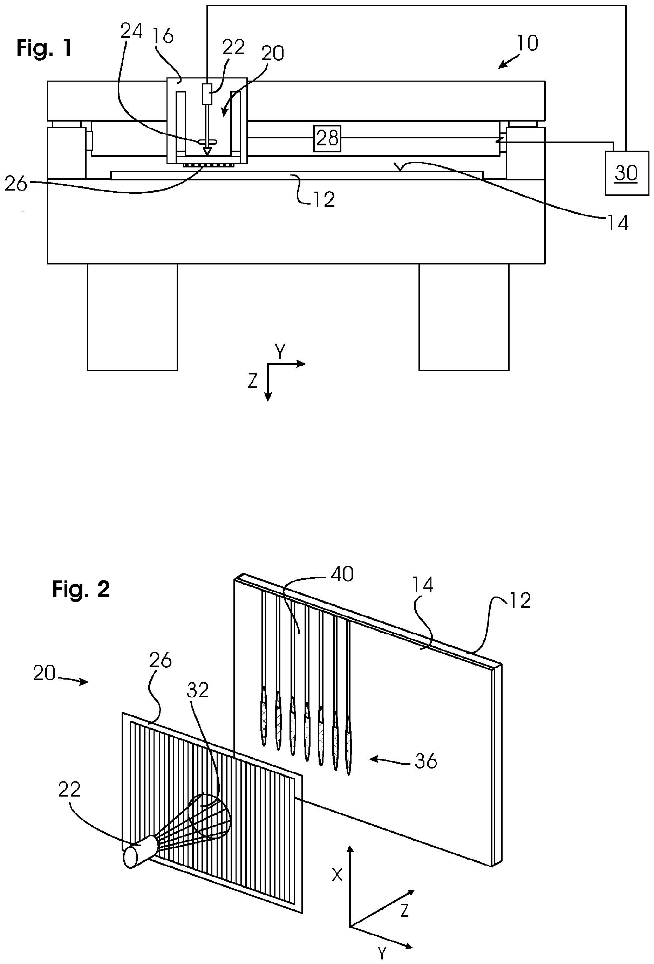

Figur 1 zeigt schematisch eine Belichtungsvorrichtung 10 mit einem Tisch für ein flaches Werkstück 12 mit lichtempfindlicher Oberfläche 14, auf der eine Schicht aus Photoresist aufgebracht ist.

Oberhalb der Oberfläche 14 ist in einem geringen Abstand in einer Z-Richtung auf einem verfahrbaren Schlitten 16 eine optische Einheit 20 angeordnet mit hier nur symbolisch dargestellter Lichtquelle 22, Optik 24 und Beugungsgitter in Form einer Liniengittermaske 26. Wie nachfolgend erläutert wird, erzeugt die optische Einheit ein Beleuchtungsmuster auf der Oberfläche 14 des Werkstücks 12. Durch in Figur 1 nur schematisch dargestellte, hochgenaue Aktoren 28 wird der Schlitten 16 in einer X-Richtung parallel zu den Linien der Liniengittermaske 26 sowie in einer hierzu senkrechten Y-Richtung verfahren und positioniert. Der Schlitten 16 ist dabei besonders leichtgängig gelagert, bspw. durch Luftlagerung und kann durch geeignete Linearmotoren bewegt werden. Die Positioniervorrichtung 28 sowie die Lichtquelle 20 werden durch eine Steuervorrichtung 30 angesteuert. Für die Positionierung werden dabei externe Referenzmarkierungen verwendet und der Schlitten gemäß den Referenzmarkierungen positioniert. Die Referenzmarkierungen können bspw. auf Glasstäben aufgebracht sein.

In Figur 2 bis 4 sind die Funktion der optischen Einheit 20 sowie die Form der Liniengittermaske 26 näher dargestellt. Die Liniengittermaske 26 ist rechteckig und weist ein regelmäßiges Liniengitter einer Gitterperiode von beispielsweise 200 nm bis 1 µm auf.

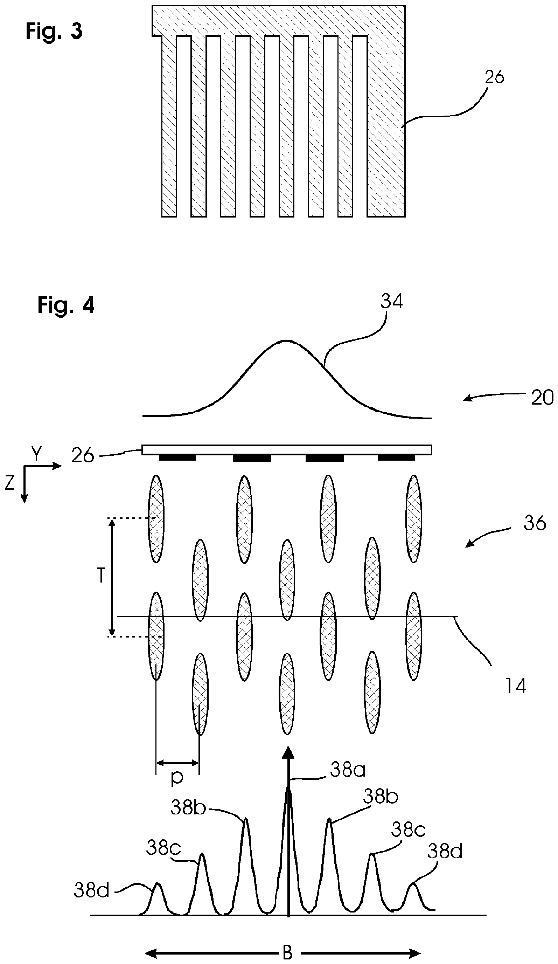

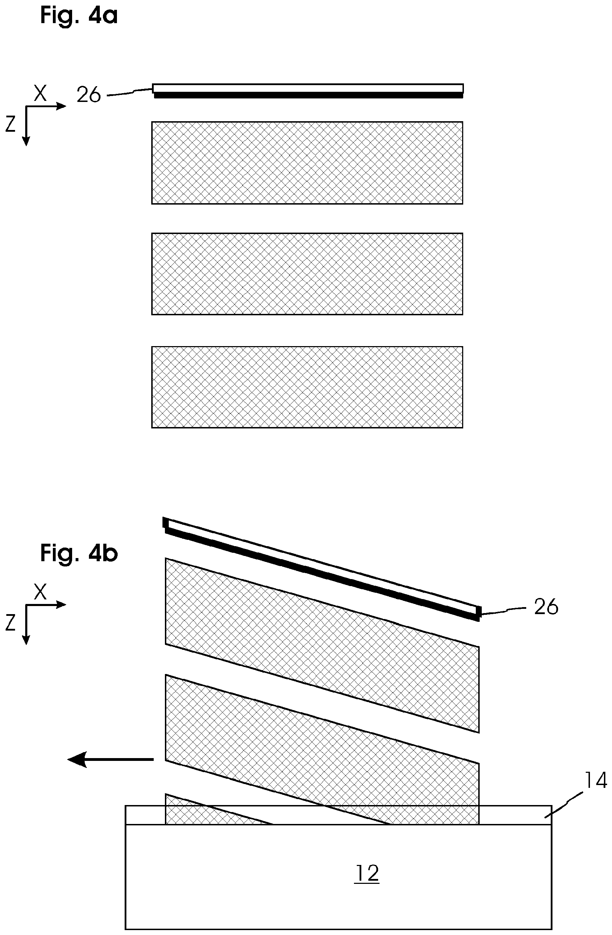

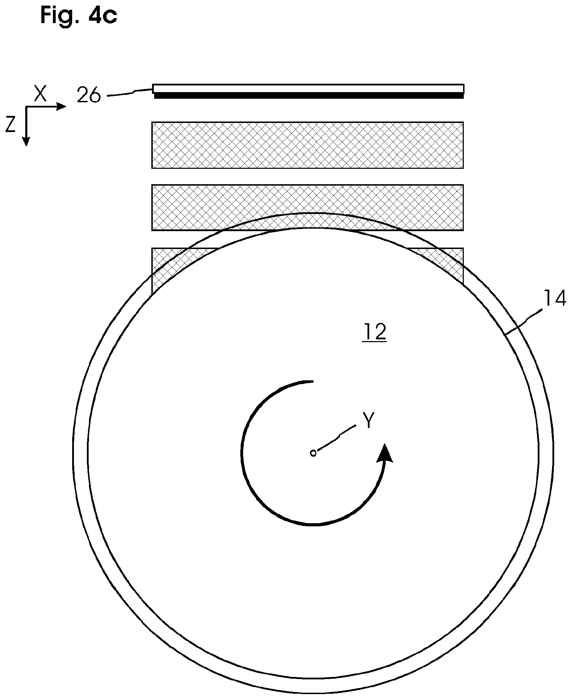

Die Lichtquelle 22 erzeugt, ggf. mit Hilfe der Optik 24, einen Beleuchtungsfleck 32 auf der Oberfläche der Maske 26. Der Beleuchtungsfleck 32 erstreckt sich im gezeigten Beispiel nicht bis zum Rand der Maske 26. In Figur 4 ist beispielhaft eine Intensitätsverteilung 34 des Beleuchtungsflecks 32 als Gauß-Verteilung gezeigt. Die Breite des Beleuchtungsflecks 32 wird nach einem 6σ -Kriterium (Abfall der Intensität auf 0,00034%) bestimmt.

Bei Verwendung einer hinreichend kohärenten Lichtquelle 22 mit einer Kohärenzlänge von beispielsweise mindestens 5µm, bevorzugt mindestens 50 µm sowie bei Verwendung einer Lichtquelle 22 mit Licht einer Wellenlänge, die kleiner ist als die Gitterperiode, ergibt sich ein Interferenzmuster 36 hinter der Maske 26, wie es in Figur 4 schematisch dargestellt ist. Das Interferenzmuster 36 weist in Y-Richtung eine Musterperiode p auf, die dem Doppelten der Gitterperiode der Maske 26 entspricht.

Unten in Figur 4 ist eine Intensitätsverteilung des Interferenzmusters 36 in der Ebene der Oberfläche 14 des Werkstücks angegeben. Wie dort gezeigt umfasst das Interferenzmuster 36 ein zentrales Hauptmaximum 38a und zu beiden Seiten äquidistant jeweils an die Musterperiode p beabstandete, kontinuierlich abnehmende Nebenmaxima 38b, 38c, 38d, usw. Die Hüllkurve über die Maxima 38a, 38b, 38c, 38d entspricht wiederum etwa einer Gauß-Kurve.

Eine Musterbreite B lässt sich nach dem bereits o.g. 6σ-Kriterium definieren durch den Abstand derjenigen Nebenmaxima, bei denen die Intensität gegenüber dem Hauptmaximum 38a auf 0,00034% abgefallen ist.

Allerdings ist das Interferenzmuster 36 wie in Fig. 4 angedeutet in Z-Richtung, d.h. Richtung der optischen Achse nicht gleichförmig, sondern weist lokale Maxima und Minima auf, was als Talbot-Effekt bekannt ist.

In Z-Richtung ergibt sich hinter der Maske 26 die angedeutete Verteilung ("Talbot-Teppich") mit einer Talbot-Periode T. Das auf der Oberfläche 14 innerhalb der Photoresist-Schicht erzeugte Streifenmuster ist somit ebenfalls nicht homogen; seine Intensitätsverteilung hängt maßgeblich vom Abstand der Oberfläche 14 von der Maske 26 ab, weist also ein sehr geringe Tiefenschärfe auf. Wie aus der schematischen Seitenansicht in Fig. 4a ersichtlich ist, ergeben sich X-Richtung verlaufende, in Z-Richtung beabstandete Streifen.

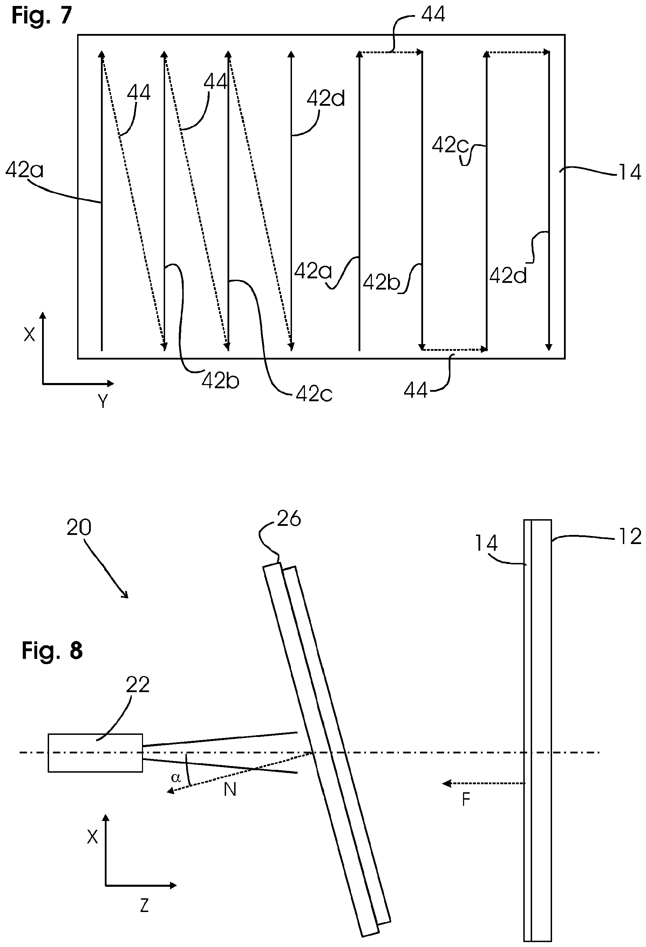

Diesem Problem wird durch eine schräge Anstellung der Maske 26 gegenüber der Oberfläche 15 begegnet, die weiter unten im Hinblick auf Fig. 8-10 sowie Fig. 4b, 4c näher erläutert wird. Die Maske 26 ist allerdings nur um einen geringen Winkel schräg angestellt, was in den Darstellungen von Fig. 1, 2 und 4 nicht sichtbar ist.

Wie in Figur 2 schematisch gezeigt, wird die lichtempfindliche Oberfläche 14 des Werkstücks 12 durch die optische Einheit 20 mit dem Interferenzmuster 36 als Beleuchtungsmuster beleuchtet, so dass der Photoresist auf der Oberfläche 14 belichtet wird. Dabei wird die optische Einheit 20 bei aktivierter Lichtquelle 22 relativ zur Oberfläche 14 des Werkstücks 12 in X-Richtung, also in Längsrichtung des Streifenmusters, bewegt. So ergibt sich die in Figur 2 schematisch dargestellte streifenförmige belichtete Struktur 40.

Das Verfahren der optischen Einheit 20 gegenüber dem Werkstück 12 in der X-Richtung wird hier als Verfahrweg bezeichnet. Die bei einem einzelnen Verfahrweg auf der Oberfläche 14 erzeugte belichtete Struktur 40 umfasst parallele Streifen, die allerdings nicht gleichmäßig belichtet sind. Aufgrund der in Figur 4 unten dargestellten, zu den Rändern hin abnehmenden Intensitätsverteilung ergibt sich innerhalb der belichteten Struktur 40 eine unterschiedliche Belichtungsdosis der einzelnen Streifen.

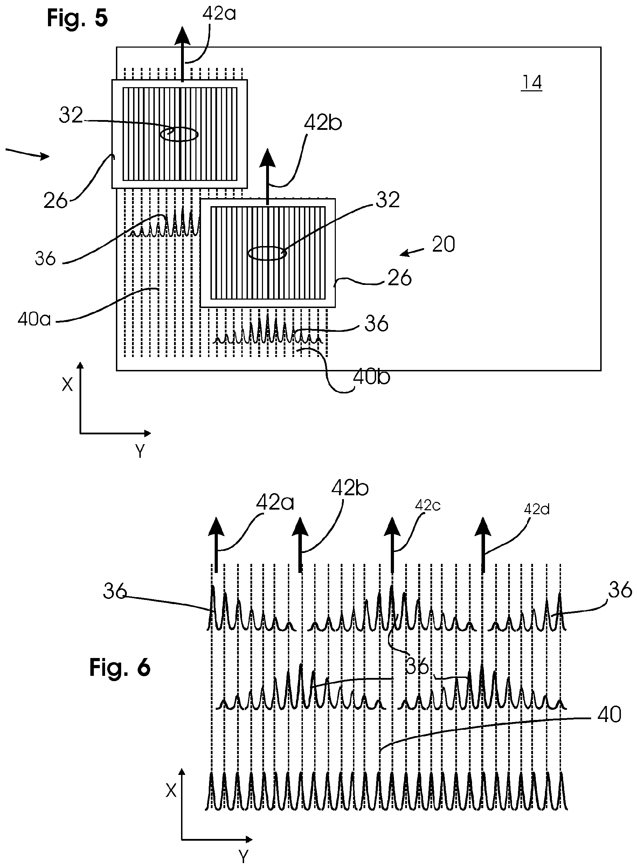

Um dies auszugleichen, wird wie in Figur 5 und Figur 6 dargestellt die Oberfläche 14 in mehreren parallelen Verfahrwegen 42a, 42b, 42c, 42d überstrichen. Die Verfahrwege 42a bis d sind jeweils parallel zueinander angeordnet und in Y-Richtung um eine Distanz d versetzt zueinander angeordnet. Die Distanz d ist dabei kleiner als die Musterbreite B, so dass sich eine Überlappung der jeweils erzeugten belichteten Strukturen 40a, 40b ergibt.

Dabei erfolgt eine sehr genaue Positionierung der optischen Einheit 20 in Y-Richtung, so dass eine phasengleiche Überlagerung erreicht wird, bei der sich jeweils Maxima der Beleuchtungsmuster 36 konstruktiv überlagern, wobei sich entlang der Streifen die jeweilige Belichtungsdosis addiert. Der Versatz d der Verfahrwege 42a bis d in Y-Richtung entspricht dabei möglichst genau (mit Abweichungen von weniger als 20 %) einem ganzzahligen Vielfachen der Musterperiode, so dass die durch die Maxima 38a bis d erzeugten Streifen möglichst exakt aufeinander liegen. Die genaue Positionierung erfolgt anhand von Referenzmarkierungen, die bspw. lithografisch auf Glasstäben aufgebracht sind.

Die Überlagerung ist schematisch in Figur 6 dargestellt. Aus den einzelnen Beleuchtungsmustern 36 werden in aufeinander folgenden Verfahrwegen 42a bis d resultierende belichtete Strukturen 40 auf der Oberfläche 14 erzeugt, bei der die Belichtungsdosis wie unten in Figur 6 gezeigt eine regelmäßige Struktur mit in etwa gleich hohen Maxima aufweist.

Auf diese Weise kann durch aufeinanderfolgende Belichtungsschritte, bei denen jeweils eine Relativbewegung zwischen der optischen Einheit 20 und der Substratoberfläche 14 in X-Richtung entlang einem Verfahrweg erfolgt, erreicht werden, dass gewünschte streifenförmige Belichtungsmuster 40 auf der gesamten Oberfläche 14 erzeugt werden.

In einer beispielhaften Ausführungsform wird Laserlicht eines Festkörper-Lasers mit einer Wellenlänge von 266 nm verwendet, das durch eine geeignete Prismen-Optik 24 zu einem Beleuchtungsfleck 32 mit einer Breite in Y-Richtung von 10mm und einer Breite in X-Richtung von nur 0,5 mm geformt wird.

Bei der Maske 26 handelt es sich im Beispiel um ein Amplitudengitter (bspw. Schattenmaske mit einer Streifenbreite, die 50% der Gitterperiode entspricht) einer Gitterperiode von 270 nm. Dieses weist eine Breite in Y-Richtung von 20mm oder mehr auf, so dass sichergestellt ist, dass der 10mm breite Beleuchtungsfleck nicht bis zu den Rändern reicht.

Hierdurch ergibt sich hinter der Maske 26 ein Interferenzmuster 36 mit einer Musterperiode, die der Hälfte der Gitterperiode entspricht, also 135 nm. Auf der mit einem Abstand von 50µm hinter der Maske 26 angeordneten Oberfläche 14 des Werkstücks hat das Interferenzmuster 36 eine Musterbreite (6σ), die der Breite des Beleuchtungsflecks 32 von 10 mm entspricht. Dabei fällt die Intensität vom Hauptmaximum zu den Seiten gemäß einer Gauß-Kurve ab.

Als Versatz d kann nun bspw. ca. ein Drittel der Musterbreite gewählt werden (was in etwa einer 1σ - Breite der Gauß-Verteilung entspricht). Der exakte Wert d für den Versatz muss dabei einem ganzzahligen Vielfachen von 135nm entsprechen. Dann ergibt sich bei den aufeinanderfolgenden Belichtungen in der Summe ein gleichmäßiges Muster, bei dem die Belichtungsdosis der Maxima von einem Mittelwert um weniger als 10% abweichen.

In Figur 7 sind beispielhaft Wegfolgen für die Bewegung der optischen Einheit 20 und somit des Beleuchtungsmusters 36 gegenüber der Oberfläche 14 dargestellt. Die links dargestellte erste Wegfolge umfasst parallele Verfahrwege 42a bis d, die jeweils gleichsinnig parallel nacheinander durchlaufen werden. Zwischen den Verfahrwegen 42 a bis d bewegt sich die optische Einheit entlang diagonalen Versatzwegen 44. Dabei ist die Lichtquelle 22 durch die Steuerung 30 deaktiviert, so dass sich während der Versatzwege 44 keine Belichtung ergibt. Die Versatzwege 44 dienen dazu, den gewünschten Versatz d in Y-Richtung herzustellen sowie die optische Einheit 20 auch in X-Richtung jeweils an den Anfang des nächsten Verfahrwegs 42 zu setzen.

Bei dem zweiten Beispiel einer Wegfolge auf der rechten Seite der Figur 7 werden die Verfahrwege 42 a bis d jeweils abwechselnd gegensinnig durchlaufen, so dass die dazwischen angeordneten Versatzwege 44 nur in Y-Richtung weisen.

Mit einer entsprechenden Wegfolge, beispielsweise gemäß einem der beiden in Figur 7 dargestellten Beispiele, kann die gesamte Oberfläche 14 überstrichen und ein resultierendes Belichtungsmuster 40 auf der Oberfläche 14 erzeugt werden.

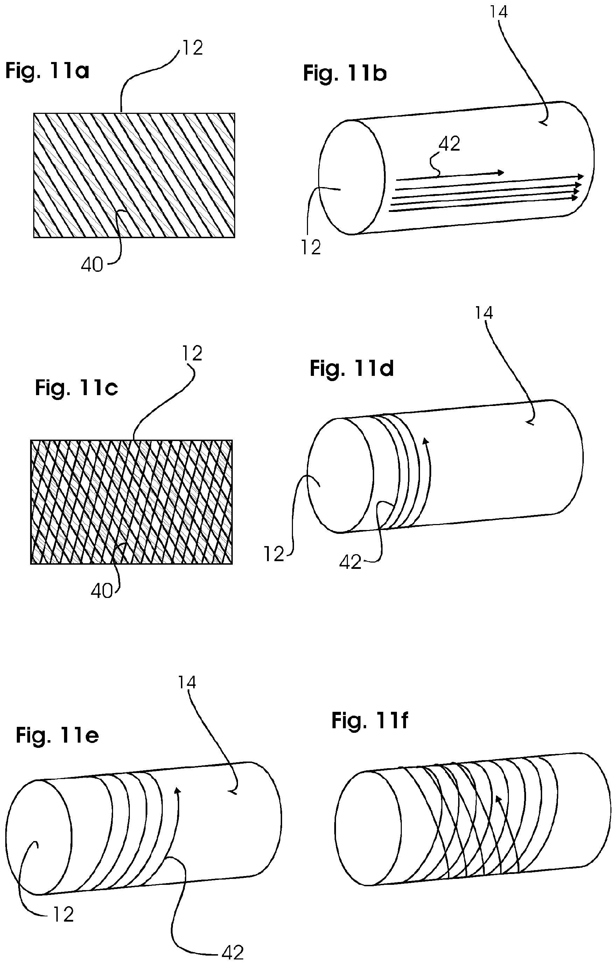

Figur 11a bis 11f zeigen für verschiedene Werkstücke und Oberflächen Beispiele von Wegfolgen.

Beispielsweise ist in Figur 11a auf einem rechteckigen Substrat ein streifenförmiges Belichtungsmuster 40 gezeigt. Die Streifen des Musters 40 sind dabei schräg angeordnet. Dieser Verlauf des Musters 40 kann beispielsweise erzielt werden, indem das Werkstück 12 in der entsprechenden Ausrichtung auf dem Tisch der Vorrichtung 10 platziert und dann gemäß einer der in Figur 7 gezeigten Wegfolgen belichtet wird.

Ein kreuzförmiges Muster 40 wie in Figur 11c dargestellt kann durch Überlagerung zweier linien- bzw. streifenförmiger Muster erzeugt werden. Dabei wird zunächst in einer ersten Ausrichtung des Werkstücks 12 ein erstes Linienmuster erzeugt. Anschließend wird das Substrat auf dem Tisch um einen Winkel von beispielsweise 30 Grad oder 60 Grad gedreht und mit demselben Verfahren ein zweites linienförmiges Muster überlagert.

In gleicher Weise wie oben beispielhaft für ein flaches Werkstück 12 dargestellt, können auch für anders geformte Werkstücke belichtete Oberflächenstrukturen erzeugt werden, beispielsweise auf Zylinderoberflächen. Zylinderoberflächen sind deshalb von besonderer Bedeutung, weil hieraus Druck- beziehungsweise Profilwalzen für die Vervielfältigung eines Musters hergestellt werden können.

Beispielhaft zeigt Figur 11b parallele Verfahrwege 42 auf der Oberfläche 14 eines zylinderförmigen Werkstücks 12. Dazu wird die Vorrichtung 10 aus Figur 1 so abgewandelt, dass an dem Tisch eine drehbare Aufnahme für das zylinderförmige Werkstück 12 so vorgesehen ist, dass dessen Längsachse in X-Richtung ausgerichtet ist. In parallelen Verfahrwegen 42 in X-Richtung werden wie oben beschrieben überlappende belichtete Strukturen aufgebracht, wobei der erforderliche Versatz durch Drehen des Zylinders erreicht wird, sodass eine gleichmäßige streifenförmige belichtete Struktur auf der Zylinderoberfläche 14 entsteht. Um eine nahtlose Strukturierung des Zylinders 12 zu erreichen, ist es bevorzugt, dass einerseits der Umfang ein ganzzahliges Vielfaches des gewählten Versatzes d in Querrichtung entspricht. Weiter ist es vorteilhaft, wenn der Umfang ein ganzzahliges Vielfaches der Musterperiode ist. Sofern eine dieser Bedingungen nicht exakt erfüllt wird, können ggfs. Anpassungen vorgenommen werden, um die Abmessungen den bevorzugten Idealmaßen möglichst anzugleichen.

In einer alternativen Ausführung gemäß Figur 11d ist das zylinderförmige Werkstück 12 mit seiner Längsachse in Y-Richtung in der Vorrichtung 10 aufgenommen. Ein Verfahren des Schlittens 16 in X-Richtung entfällt hier; stattdessen wird der Zylinder 12 gedreht, so dass sich jeweils kreisförmige Verfahrwege 42 auf der Oberfläche 14 ergeben. Durch ein Verfahren des Schlittens 16 in Y-Richtung, also entlang der Längsachse des Zylinders 12, werden in aufeinander folgenden parallelen Verfahrwegen 42 überlappende belichtete Strukturen zu einer belichteten Gesamtstruktur überlagert.

Eine besonders bevorzugte Wegfolge für die Erzeugung einer belichteten Struktur auf einer Zylinderoberfläche 14 zeigt Figur 11e. Dabei läuft ein einziger Verfahrweg 42 als Spirale um den Zylinder 12 herum, wobei die einzelnen Windungen zueinander jeweils parallel im Überlagerungsabstand d angeordnet sind, so dass sich eine gewünschte schraubenförmige Struktur ergibt. Zur Erzeugung dieser Struktur mit einer leicht modifizierten Vorrichtung 10 ist eine Aufnahme des Zylinders 12 mit Ausrichtung in Y-Richtung sowie eine leichte Drehung der Maske 26 der optischen Einheit 20 erforderlich, so dass die Gitterlinien parallel zu den jeweiligen Schraubenwindungen stehen. Die Maske 26 kann dabei entsprechend der Krümmung der Zylinderoberfläche 14 ebenfalls leicht gekrümmt sein. Bei der Erzeugung der belichteten Struktur wird der Zylinder 12 kontinuierlich um die Längsachse gedreht, während synchron zu der Steigung der einzelnen Windungen der Schlitten 16 in Y-Richtung verfährt. So wird die gewünschte Überlagerung der einzelnen belichteten Strukturen zu einer regelmäßigen belichteten Gesamtstruktur erreicht.

Auch bei einer Zylinderoberfläche kann durch eine Wiederholung des oben genannten Verfahrens unter einem anderen Winkel eine Kreuzstruktur erreicht werden, wie in Figur 11f dargestellt, bspw. mit einer 30 Grad oder 6o Grad Steigung von der einen Seite und anschließend 30° oder 60° Steigung in entgegengesetzte Richtung.

Nachfolgend werden verschiedene Ausführungsformen für die schräge Anstellung der Maske 26 gegenüber der Oberfläche 14 beschrieben.

Figur 8 zeigt eine erste bevorzugte Ausführung der optischen Einheit 20, bei der die Maske 26 gegenüber der Lichtquelle 22 leicht angestellt ist. In dieser Ausführung ist zwar die Oberfläche 14 des Werkstücks 12 senkrecht zur optischen Achse, aber die Oberfläche der Maske 16 nicht senkrecht zur optischen Achse des Lichteinfalls von der Lichtquelle 22, sondern unter einem geringen Winkel α hierzu angeordnet. Der Winkel α lässt sich zwischen einer senkrecht auf der Oberfläche der Maske stehenden Normalrichtung N und der durch den Lichteinfall vorgegebenen optischen Achse messen, die in diesem Beispiel parallel zur Normalenrichtung F der Oberfläche 14 ist.

Die Maske 26 ist um eine in Y-Richtung, das heißt quer zum Liniengitter verlaufende Achse gedreht.

Fig. 4b zeigt die sich bei schräg angestellter Maske 26 ergebende Intensitätsverteilung. Die bei gerader Positionierung der Maske 26 parallel zur X-Richtung verlaufenden, in Z-Richtung beabstandeten Streifen verlaufen bei schräg angestellter Maske schräg zur Oberfläche 14. Hierdurch werden während des Verfahrwegs in X-Richtung auf der Oberfläche 14 Talbot-Perioden durchfahren und so Intensitätsunterschiede des Interferenzfeldes in Z-Richtung ausgeglichen, so dass sich eine in X-Richtung stets gleichbleibende Belichtungsdosis ergibt.

Die Schrägstellung der Maske 26 ist in Fig. 8, 4b aus darstellerischen Gründen übertrieben deutlich gezeigt, in praktischen Ausführungen liegt der Winkel α zumeist bei weniger als 2°.

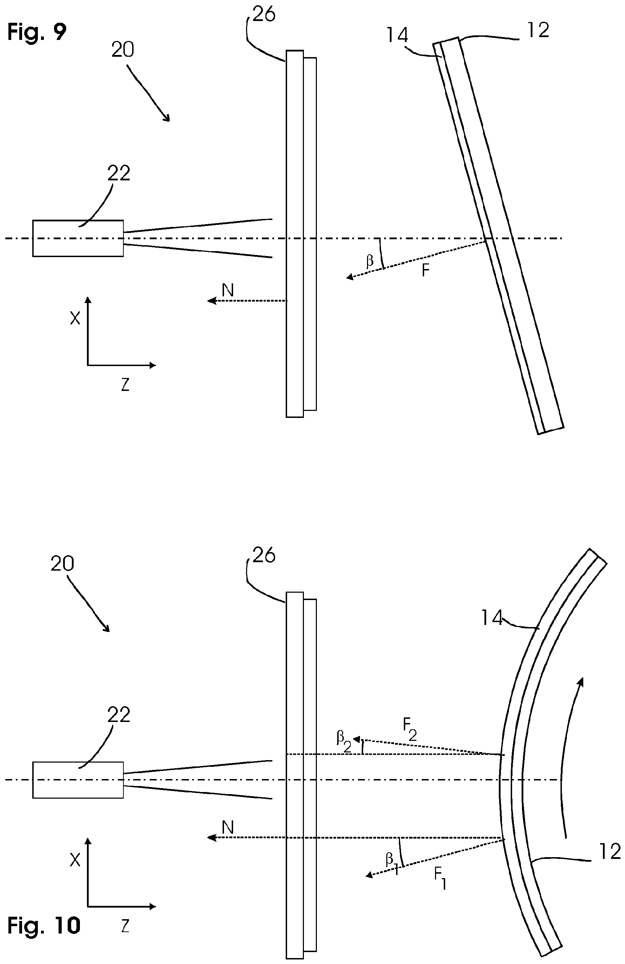

Fig. 9 zeigt eine zweite Ausführung der optischen Einheit 20, bei der zwar der die Maske 26 gegenüber der Lichtquelle 22 senkrecht ausgerichtet ist (Normalenrichtung N der Maske 26 ist parallel zur optischen Achse der Lichtquelle 22), aber die optische Einheit 20 insgesamt gegenüber der Oberfläche 14 unter einem Winkel β leicht angestellt ist. Der Winkel β lässt sich zwischen der Normalrichtung N bzw. der hierzu parallelen optischen Achse der Lichtquelle 22 und der Normalenrichtung F der Oberfläche 14 messen.

Auch hier ergibt sich die schematisch in Fig. 4b gezeigte Anordnung mit einer Schrägstellung des Talbot-Teppichs. Bei der Bewegung in X-Richtung werden Talbot-Perioden durchlaufen und es ergibt sich ein Ausgleich der Intensität entlang der X-Richtung.

Auch hier gilt, dass die Schrägstellung der optischen Einheit 20 in Fig. 9 aus darstellerischen Gründen übertrieben deutlich gezeigt ist, in praktischen Ausführungen der Winkel β allerdings zumeist weniger als 20 betragen wird.

Schließlich zeigt Fig. 10 eine dritte Ausführungsform mit Anordnung der optischen Einheit 10 vor der Oberfläche 14. Bei dieser Ausführungsform ist die Maske 26 gegenüber der Lichtquelle 22 senkrecht ausgerichtet (Normalenrichtung N der Maske 26 parallel zur optischen Achse der Lichtquelle 22).

Bei der dritten Ausführungsform weist der Körper 12 eine gekrümmt Oberfläche 14 auf, so dass sich an verschiedenen Stellen der Oberfläche 14 verschieden ausgerichtete Flächennormalen F1, F2 ergeben. Durch die flächige Ausdehnung des Beleuchtungsflecks 32 auf der Oberflächd 14 ergeben sich in jedem Fall Schrägstellungen zwischen der Oberfläche 14 und der Ebene der Maske 26. Beispielhaft sind hier (aus zeichnerischen Zwecken übertrieben stark) die Winkel β1 und β2 eingezeichnet.

Beispielsweise kann es sich um einen zylinderförmigen Körper 12 handeln, der wie in Fig. 11d-11f gezeigt rotiert wird.

Schematisch sind die Verhältnisse in Fig. 4c gezeigt. Bei einer Drehung um die Y-Achse in Fig. 10, Fig 4c, also um eine zur optischen Achse und zur Längsrichtung der Maske 26 senkrechte Achse, werden die Talbot-Perioden durchlaufen und es ergibt sich durch die Schrägstellung sowie durch die verschiedenen Abstände zwischen der Maske 26 und der Oberfläche 14 der gewünschte Ausgleich der Maximal in Z-Richtung, so dass sich in Umfangsrichtung durch den Ausgleich der Intensitäten entlang der Streifen ein scharfes Streifenmuster ergibt.

Bei den angegebenen Ausführungsformen handelt es sich jeweils um Beispiele; die Erfindung ist allerdings nicht hierauf beschränkt. Zu den Ausführungen sind jeweils Änderungen möglich. So kann bspw. statt des runden Beleuchtungsflecks 30 auf der Maske 26 auch eine andere Form gewählt werden, die beispielsweise in Y-Richtung breiter ist als in X-Richtung. Dies kann durch eine geeignete Optik 24 erreicht werden.

Während in den vorstehend beschriebenen Ausführungen davon ausgegangen wurde, dass sich zwischen der Maske 26 und der Oberfläche 14 des Körpers Luft befindet, können durch Verwendung eines optisch dichteren Mediums bei gleichbleibender Beleuchtungswellenlänge noch feinere Strukturen erzeugt werden. Dies ist als Immersions-Belichtung bekannt, allerdings üblicherweise für feststehende Anordnungen. Im Rahmen einer möglichen Ausführungsform kann das optisch dichtere Medium bspw. als Gleitfilm, z.B. aus Glyzerin, zwischen Maske und Oberfläche angeordnet sein. Ein aus dem optisch dichteren Medium gebildeter Gleitfilm kann bspw. auf der Oberfläche 14 des Körpers aufgetragen werden.

In dem optisch dichteren Medium hat das Licht dann eine kürzere Wellenlänge, so dass sich Strukturen erzeugen lassen, die um den Faktor des relativen Berechungsindex des optisch dichteren Mediums feiner sind. Bspw. kann bei Verwendung von Laserlicht einer Wellenlänge von 266 nm ein Gitter von 190 nm verwendet werden, weil die Wellenlänge des Lichts in einem Medium mit einem Brechungsindex von 1,5 nur 177 nm beträgt. So sind Strukturen von 95nm zu erreichen, was ohne das optisch dichtere Medium mit dem 266nm-Laserlicht nicht möglich wäre.

## Patentansprüche

1. Vorrichtung zur Erzeugung von belichteten Strukturen auf einem Werkstück (12) mit lichtempfindlicher Oberfläche (14), mit
- einer Aufnahme für das Werkstück (12),
- einer optischen Einheit (20) umfassend eine kohärente Lichtquelle (22) und ein ebenes Beugungsgitter (26) zur Erzeugung eines streifenförmigen Beleuchtungsmusters (36) mit in einer Längsrichtung (X) verlaufenden Streifen und mit einer sich in einer Querrichtung erstreckenden Musterbreite (B) auf der Oberfläche (14) des Werkstücks (12), wobei das Beugungsgitter (26) gegenüber zumindest einem Teil der durch das Beleuchtungsmuster (36) belichteten Oberfläche (14) des Werkstücks (12) schräg angestellt ist,
- einer Vorrichtung (28) zum Verfahren der Oberfläche (14) des Werkstücks (12) und der optischen Einheit (20) gegeneinander, wobei die Vorrichtung (28) ausgebildet ist zum Verfahren gemäß einer Wegfolge,
- wobei die Wegfolge mindestens einen ersten Verfahrweg (42a - d) in der Längsrichtung (X) umfasst, um auf der Oberfläche (14) des Werkstücks (12) eine erste belichtete Struktur (40a) mit Streifen zu erzeugen,
**dadurch gekennzeichnet, dass**
- das Beleuchtungsmuster (36) eine Intensitätsverteilung aufweist, bei der die Intensität der die Streifen bildenden Maxima in Querrichtung von der Mitte her zu den Rändern abnimmt,
- die Wegfolge mindestens einen zweiten Verfahrweg (42a - d) in der Längsrichtung (X) umfasst, um auf der Oberfläche (14) des Werkstücks (12) eine zweite belichtete Struktur (40b) mit Streifen zu erzeugen, die parallel zur ersten belichteten Struktur ausgerichtet ist,
- wobei der erste und zweite Verfahrweg (42a - d) um weniger als die Musterbreite (B) voneinander beabstandet sind,
- und wobei sich die erste und zweite belichtete Struktur (40a, 40b) so überlappen, dass Streifen der ersten und zweiten belichteten Struktur aufeinander liegend angeordnet sind.

2. Vorrichtung nach Anspruch 1, bei der
- das Beugungsgitter (26) und die Lichtquelle (22) so angeordnet sind, dass das Licht der Lichtquelle (22) unter einem Winkel (α) zu einer zur Oberfläche des Beugungsgitters (26) senkrechten Normalrichtung (N) auf das Beugungsgitter (26) fällt.

3. Vorrichtung nach Anspruch 1, bei der
- das Beugungsgitter (26) und das Werkstück (12) so angeordnet sind, dass zumindest in einem Teil der von dem Beleuchtungsmuster (36) belichteten Oberfläche (14) des Werkstücks (12) eine Flächennormale (F) der Oberfläche (14) unter einem Winkel (β) zu einer zur Oberfläche des Beugungsgitters (26) senkrechten Normalrichtung (N) angeordnet ist.

4. Vorrichtung nach Anspruch 3, bei der
- die Oberfläche (14) des Werkstücks (12) gekrümmt ist.

5. Vorrichtung nach Anspruch 4, bei der
- die Verfahrvorrichtung (28) eine Vorrichtung zum Drehen des Werkstücks (12) umfasst.

6. Vorrichtung nach einem der vorangehenden Ansprüche, bei der
- eine Ansteuervorrichtung (30) zur automatischen Ansteuerung der Verfahrvorrichtung (28) gemäß der Wegfolge vorgesehen ist.

7. Vorrichtung nach einem der vorangehenden Ansprüche, bei der
- eine Positioniervorrichtung vorgesehen ist zur Positionierung der optischen Einheit (20) so, dass Streifen der ersten und zweiten belichteten Struktur (40a, 40b) aufeinander liegend angeordnet sind,
- wobei die Wegfolge so gewählt ist, dass eine belichtete Struktur (40) auf der Oberfläche (14) des Werkstücks (12) mindestens im Überlappungsbereich zweier Verfahrwege (42a - d) eine mindestens im Wesentlichen konstante Belichtung aufweisen.

8. Vorrichtung nach einem der vorangehenden Ansprüche, bei der
- die optische Einheit (20) ausgebildet ist zur Erzeugung eines streifenförmigen Beleuchtungsmusters (36) mit einer Musterperiode,
- und die Wegfolge zwischen zwei Verfahrwegen (42a - d) in Längsrichtung (X) einen Versatzweg (44) aufweist, wobei die optische Einheit (20) quer zur Längsrichtung (X) um eine Versatzstrecke versetzt wird, die ein ganzzahliges Vielfaches der Musterperiode und kleiner als die Musterbreite (B) ist.

9. Vorrichtung nach einem der vorangehenden Ansprüche, bei der
- die Wegfolge eine Mehrzahl von parallelen Verfahrwegen (42a - d) in Längsrichtung (X) umfasst, um durch parallele, überlappende belichtete Strukturen (40a, 40b) auf der Oberfläche (14) des Werkstücks (12) eine belichtete Gesamtstruktur (40) mit parallelen Streifen zu erzeugen.

10. Vorrichtung nach einem der vorangehenden Ansprüche, bei der
- die optische Einheit (20) eine Optik (24) zur Erzeugung eines Beleuchtungsflecks (32) auf dem Beugungsgitter (26) umfasst, wobei der Beleuchtungsfleck in der Längsrichtung (X) eine geringere Ausdehnung hat als in einer senkrecht hierzu verlaufenden Querrichtung (Y).

11. Vorrichtung nach einem der vorangehenden Ansprüche, bei der
- die optische Einheit (20) eine Optik (24) zur Erzeugung eines Beleuchtungsflecks (32) auf dem Beugungsgitter (26) umfasst, wobei das Beugungsgitter (26) zumindest in einer senkrecht zur Längsrichtung (X) verlaufenden Querrichtung (Y) eine größere Ausdehnung hat als der Beleuchtungsfleck (32).

12. Vorrichtung nach einem der vorangehenden Ansprüche, bei der
- auf der Oberfläche des Werkstücks (12) ein Fotolack (14) aufgebracht ist.

13. Verfahren zur Erzeugung von belichteten Strukturen auf einem Werkstück (12) mit lichtempfindlicher Oberfläche (14), bei dem
- ein streifenförmiges Beleuchtungsmuster (36) mit in einer Längsrichtung (X) verlaufenden Streifen und mit einer sich in einer Querrichtung (Y) erstreckenden Musterbreite (B) erzeugt wird durch Beleuchtung eines ebenen Beugungsgitters (26) mit kohärentem Licht, wobei das Beugungsgitter (26) gegenüber zumindest einem Teil der durch das Beleuchtungsmuster (36) belichteten Oberfläche (14) des Werkstücks (12) schräg angestellt ist,
- das Beleuchtungsmuster (36) und die Oberfläche (14) des Werkstücks (12) gemäß einer Wegfolge relativ zueinander bewegt werden, um auf der Oberfläche (14) des Werkstücks (12) mindestens eine erste belichtete Struktur (40a) mit Streifen zu erzeugen,
**dadurch gekennzeichnet, dass**
- das Beleuchtungsmuster (36) eine Intensitätsverteilung aufweist, bei der die Intensität der die Streifen bildenden Maxima in Querrichtung von der Mitte her zu den Rändern abnimmt,
- das Beleuchtungsmuster (36) und die Oberfläche (14) des Werkstücks (12) gemäß der Wegfolge relativ zueinander bewegt werden, um auf der Oberfläche (14) des Werkstücks (12) mindestens eine zweite belichtete Struktur (40b) mit Streifen zu erzeugen,
- wobei die Wegfolge mindestens zwei parallele Verfahrwege (42a - d) in Längsrichtung (X) umfasst, die um weniger als die Musterbreite (B) voneinander beabstandet sind, und wobei sich die erste und zweite belichtete Struktur (40a, 40b) so überlappen, dass Streifen der ersten und zweiten belichteten Struktur (40a, 40b) aufeinander liegend angeordnet sind.

14. Verfahren nach Anspruch 13, bei dem
- durch Überlagerung mindestens der ersten und der zweiten belichteten Struktur (40a, 40b) eine erste belichtete Gesamtstruktur (40) auf der Oberfläche (14) erzeugt wird, die Streifen aufweist, die in einer ersten Längsrichtung (X) verlaufen,
- und wobei durch eine relative Bewegung des Beleuchtungsmusters (36) und der Oberfläche (14) in einer zweiten Längsrichtung, die einen Winkel zur ersten Längsrichtung (X) aufweist, eine die erste belichtete Gesamtstruktur (40) überkreuzende zweite belichtete Gesamtstruktur (40) auf der Oberfläche (14) erzeugt wird.

## Claims

1. A device for producing light-exposed structures on a workpiece (12) having a light-sensitive surface (14) with
- a seat for the workpiece (12),
- an optical unit (20) comprising a coherent light source (22) and a flat diffraction grating (26) for generating a strip-shaped illumination pattern (36) having strips extending in a longitudinal direction (X) and having a pattern width (B) extending in a transverse direction on the surface (14) of the workpiece (12), wherein the diffraction grating (26) is obliquely tilted relative to at least part of the surface (14) of the workpiece (12) that is light-exposed by the illumination pattern (36),
- a device (28) for moving the surface (14) of the workpiece (12) and the optical unit (20) relative to each other, wherein the device (28) is designed to move in accordance with a path sequence,
- wherein the path sequence comprises at least a first movement path (42a - d) in the longitudinal direction (X) in order to generate a first light-exposed structure (40a) on the surface (14) of the workpiece (12), said structures having strips,
**characterized in that**
- the illumination pattern (36) has an intensity distribution in which the intensity of the maxima forming the stripes decreases in the transverse direction from the center towards the edges,
- the path sequence comprises at least a second movement path (42a - d) in the longitudinal direction (X) in order to generate a second light-exposed structure (40b) on the surface (14) of the workpiece (12), said structure having strips, which are oriented parallel to the first illuminated pattern,
- wherein the first and second movement path (42a - d) are spaced apart from each other by less than the pattern width (B),
- and wherein the first and second light-exposed structures (40a, 40b) overlap in such a way that strips of the first and second light-exposed structures are arranged to lie on each other.

2. The device according to claim 1, wherein:
- the diffraction grating (26) and the light source (22) are arranged such that the light of the light source (22) falls on the diffraction grating (26) at an angle (α) to a normal direction (N) perpendicular to the surface of the diffraction grating (26).

3. The device according to claim 1, wherein:
- the diffraction grating (26) and the workpiece (12) are arranged such that, at least in part of the surface (14) of the workpiece (12) light-exposed by the illumination pattern (36), a surface normal (F) of the surface (14) is arranged at an angle (β) to a normal direction (N) perpendicular to the surface of the diffraction grating (26).

4. The device according to claim 3, wherein:
- the surface (14) of the workpiece (12) is curved.

5. The device according to claim 4, wherein:
- the moving device (28) comprises a device for rotating the workpiece (12).

6. The device according to one of the preceding claims, wherein:
- a control device (30) is provided for automatically controlling the moving device (28) according to the path sequence.

7. The device according to one of the preceding claims, wherein:
- a positioning device is provided for positioning the optical unit (20) so that the strips of the first and second light-exposed structure (40a, 40b) are arranged lying on each other,
- wherein the path sequence is selected so that a light-exposed structure (40) on the surface (14) of the workpiece (12) has an at least substantially constant light-exposure, at least in the overlapping region of two movement paths (42a - d).

8. The device according to one of the preceding claims, wherein:
- the optical unit (20) is designed to generate a strip-shaped illumination pattern (36) with a pattern period,
- and the path sequence between two movement paths (42a - d) has an offset path (44) in the longitudinal direction (X), wherein the optical unit (20) is offset transversely to the longitudinal direction (X) by an offset section that is an integral multiple of the pattern period and less than the pattern width (B).

9. The device according to one of the preceding claims, wherein:
- the path sequence comprises a plurality of parallel movement paths (42a - d) in the longitudinal direction (X) in order to generate a light-exposed overall structure (40) with parallel strips by parallel, overlapping light-exposed structures (40a, 40b) on the surface (14) of the workpiece (12).

10. The device according to one of the preceding claims, wherein:
- the optical unit (20) comprises an optical system (24) for generating an illumination spot (32) on the diffraction grating (26), wherein the illumination spot has a shorter extension in the longitudinal direction (X) than in a transverse direction (Y) running perpendicular thereto.

11. The device according to one of the preceding claims, wherein:
- the optical unit (20) comprises an optical system (24) for generating an illumination spot (32) on the diffraction grating (26), wherein the diffraction grating (26) has a longer extension, at least in a transverse direction (Y) running perpendicular to the longitudinal direction (X), than the illumination spot (32).

12. The device according to one of the preceding claims, wherein:
- a photoresist (14) is applied to the surface of the workpiece (12).

13. A method for producing light-exposed structures on a workpiece (12) having a light-sensitive surface (14), wherein
- a strip-shaped illumination pattern (36) having strips extending in a longitudinal direction (X) and having a pattern width (B) extending in a transverse direction (Y) is generated by illuminating a flat diffraction grating (26) with coherent light, wherein the diffraction grating (26) is obliquely tilted relative to at least part of the surface (14) of the workpiece (12) that is light-exposed by the illumination pattern (36),
- the illumination pattern (36) and the surface (14) of the workpiece (12) are moved relative to each other according to a path sequence in order to generate at least one first light-exposed structure (40a) with strips on the surface (14) of the workpiece (12),
**characterized in that**
- the illumination pattern (36) having an intensity distribution in which the intensity of the maxima forming the stripes decreases in the transverse direction from the center toward the edges,
- the illumination pattern (36) and the surface (14) of the workpiece (12) are moved relative to each other according to a path sequence in order to generate at least one second light-exposed structure (40b) with strips on the surface (14) of the workpiece (12),
- wherein the path sequence comprises at least two parallel movement paths (42a - d) in the longitudinal direction (X) that are spaced apart from each other by less than the pattern width (B), and wherein the first and second light-exposed structures (40a, 40b) overlap in such a way that strips of the first and second light-exposed structures (40a, 40b) are arranged to lie on each other.

14. The method according to claim 13, wherein:
- by overlapping at least the first and the second light-exposed structure (40a, 40b), a first light-exposed overall structure (40) is generated on the surface (14) that has strips which run in a first longitudinal direction (X),
- and wherein by a relative movement of the illumination pattern (36) and the surface (14) in a second longitudinal direction that has an angle relative to the first longitudinal direction (X), a second light-exposed overall structure (40) is generated on the surface (14) which crosses the first light-exposed overall structure (40).

## Revendications

1. Un dispositif pour produire des structures exposées à la luminiere sur une pièce (12) ayant une surface sensible à la luminiere (14) avec
- un siège pour la pièce à usiner (12),
- une unité optique (20) comprenant une source de lumière cohérente (22) et un réseau de diffraction plat (26) pour générer un motif d'illumination en forme de bande (36) ayant des bandes s'étendant dans une direction longitudinale (X) et ayant une largeur de motif (B) s'étendant dans une direction transversale sur la surface (14) de la pièce (12), le réseau de diffraction (26) étant incliné obliquement par rapport à au moins une partie de la surface (14) de la pièce (12) qui est exposée à la luminiere par le motif d'illumination (36),
- un dispositif (28) pour déplacer la surface (14) de la pièce (12) et l'unité optique (20) l'une par rapport à l'autre, le dispositif (28) étant conçu pour se déplacer selon une séquence de parcours,
- dans laquelle la séquence de parcours comprend au moins un premier parcours de déplacement (42a - d) dans la direction longitudinale (X) afin de générer une première structure exposée à la luminiere (40a) sur la surface (14) de la pièce (12), lesdites structures présentant des bandes,
**caractérisé par le fait que**
- le motif d'illumination (36) présente une distribution d'intensité dans laquelle l'intensité des maxima formant les bandes diminue dans la direction transversale du centre vers les bords,
- la séquence de parcours comprend au moins un deuxième parcours de déplacement (42a - d) dans la direction longitudinale (X) afin de générer une deuxième structure exposée à la luminiere (40b) sur la surface (14) de la pièce (12), ladite structure présentant des bandes et étant orientée parallèlement au premier motif illuminé,
- dans lequel le premier et le second parcours de déplacement (42a - d) sont espacés l'un de l'autre d'une distance inférieure à la largeur du motif (B),
- et dans lequel la première et la deuxième structure exposée à la luminiere (40a, 40b) se chevauchent de telle sorte que les bandes de la première et de la deuxième structure exposée à la luminiere sont disposées de manière à reposer l'une sur l'autre.

2. Le dispositif selon la revendication 1, dans lequel :
- le réseau de diffraction (26) et la source lumineuse (22) sont disposés de telle sorte que la lumière de la source lumineuse (22) tombe sur le réseau de diffraction (26) à un angle (α) par rapport à une direction normale (N) perpendiculaire à la surface du réseau de diffraction (26) .

3. Le dispositif selon la revendication 1, dans lequel :
- le réseau de diffraction (26) et la pièce (12) sont disposés de telle sorte que, au moins sur une partie de la surface (14) de la pièce (12) exposée à la lumière par le motif d'illumination (36), une normale de surface (F) de la surface (14) est disposée à un angle (β) par rapport à une direction normale (N) perpendiculaire à la surface du réseau de diffraction (26).

4. Le dispositif selon la revendication 3, dans lequel :
- la surface (14) de la pièce (12) est incurvée.

5. Le dispositif selon la revendication 4, dans lequel :
- le dispositif de déplacement (28) comprend un dispositif de rotation de la pièce (12).

6. Le dispositif selon l'une des revendications précédentes, dans lequel :
- un dispositif de commande (30) est prévu pour commander automatiquement le dispositif de déplacement (28) en fonction de la séquence de parcours.

7. Le dispositif selon l'une des revendications précédentes, dans lequel :
- un dispositif de positionnement est prévu pour positionner l'unité optique (20) de sorte que les bandes de la première et de la seconde structure exposée à la luminiere (40a, 40b) soient disposées couchées l'une sur l'autre,
- dans laquelle la séquence de parcours est sélectionnée de manière à ce qu'une structure exposée à la lumière (40) sur la surface (14) de la pièce (12) ait une exposition à la lumière au moins sensiblement constante, au moins dans la région de chevauchement de deux parcours de déplacement (42a - d).

8. Le dispositif selon l'une des revendications précédentes, dans lequel :
- l'unité optique (20) est conçue pour générer un motif d'illumination en forme de bande (36) avec une période de motif,
- et la séquence de parcours entre deux parcours de déplacement (42a - d) comporte un parcours décalé (44) dans la direction longitudinale (X), l'unité optique (20) étant décalée transversalement par rapport à la direction longitudinale (X) d'une section décalée qui est un multiple entier de la période du motif et inférieure à la largeur du motif (B).

9. Le dispositif selon l'une des revendications précédentes, dans lequel :
- la séquence de parcours comprend une pluralité de parcours de déplacement parallèles (42a - d) dans la direction longitudinale (X) afin de générer une structure globale exposée à la lumière (40) avec des bandes parallèles par des structures exposées à la lumière (40a, 40b) parallèles et se chevauchant sur la surface (14) de la pièce à usiner (12).

10. Le dispositif selon l'une des revendications précédentes, dans lequel :
- l'unité optique (20) comprend un système optique (24) pour générer une tache d'illumination (32) sur le réseau de diffraction (26), dans lequel la tache d'illumination a une extension plus courte dans la direction longitudinale (X) que dans une direction transversale (Y) perpendiculaire à celle-ci.

11. Le dispositif selon l'une des revendications précédentes, dans lequel :
- l'unité optique (20) comprend un système optique (24) pour générer une tache d'illumination (32) sur le réseau de diffraction (26), dans lequel le réseau de diffraction (26) a une extension plus longue, au moins dans une direction transversale (Y) perpendiculaire à la direction longitudinale (X), que la tache d'illumination (32) .

12. Le dispositif selon l'une des revendications précédentes, dans lequel :
- une résine photosensible (14) est appliquée sur la surface de la pièce (12).

13. Procédé de production de structures exposées à la luminiere sur une pièce (12) ayant une surface sensible à la luminiere (14), dans lequel
- un motif d'illumination en forme de bande (36) ayant des bandes s'étendant dans une direction longitudinale (X) et ayant une largeur de motif (B) s'étendant dans une direction transversale (Y) est généré en illuminant un réseau de diffraction plat (26) avec une lumière cohérente, le réseau de diffraction (26) étant incliné obliquement par rapport à au moins une partie de la surface (14) de la pièce à usiner (12) qui est exposée à la luminiere par le motif d'illumination (36),
- le motif d'illumination (36) et la surface (14) de la pièce (12) sont déplacés l'un par rapport à l'autre selon une séquence de parcours afin de générer au moins une première structure exposée à la luminiere (40a) avec des bandes sur la surface (14) de la pièce (12),
**caractérisé par le fait que**
- le motif d'illumination (36) ayant une distribution d'intensité dans laquelle l'intensité des maxima formant les bandes diminue dans la direction transversale du centre vers les bords,
- le motif d'illumination (36) et la surface (14) de la pièce (12) sont déplacés l'un par rapport à l'autre selon une séquence de parcours afin de générer au moins une seconde structure exposée à la luminiere (40b) avec des bandes sur la surface (14) de la pièce (12),
- dans laquelle la séquence de parcours comprend au moins deux parcours de déplacement parallèles (42a - d) dans la direction longitudinale (X) qui sont espacés l'un de l'autre d'une distance inférieure à la largeur du motif (B), et dans laquelle la première et la deuxième structure exposée à la lumière (40a, 40b) se chevauchent de telle sorte que les bandes de la première et de la deuxième structure exposée à la lumière (40a, 40b) sont disposées de manière à reposer l'une sur l'autre.

14. La procédé selon la revendication 13, dans laquelle :
- En superposant au moins la première et la deuxième structure exposée à la luminiere (40a, 40b), une première structure globale exposée à la luminiere (40) est générée sur la surface (14) qui présente des bandes qui s'étendent dans une première direction longitudinale (X),
- et dans lequel, par un mouvement relatif du motif d'illumination (36) et de la surface (14) dans une seconde direction longitudinale qui présente un angle par rapport à la première direction longitudinale (X), une seconde structure globale exposée à la luminiere (40) est générée sur la surface (14) qui croise la première structure globale exposée à la luminiere (40).
